# EUROPEAN PATENT APPLICATION

(11) **EP 1 720 064 A1**
(43) Date of publication of application: **08.11.2006**
(21) Application number: 06111811.3
(22) Date of filing: 28.03.2006
(51) Int. Cl.: G03F 7/075, G03F 7/004

(54) **Radiation-sensitive resin composition**

(30) Priority: 28.03.2005 JP 2005090569
(71) Applicant: JSR Corporation, Tokyo 104-8410 (JP)
(72) Inventor: Nishimura, Isao JSR Corp., Tokyo Tokyo 104-8410 (JP); Egawa, Hiromi JSR Corp., Tokyo Tokyo 104-8410 (JP); Sugie, Norihiko JSR Corp., Tokyo Tokyo 104-8410 (JP); Natsume, Norihiro JSR Corp., Tokyo Tokyo 104-8410 (JP); Takahashi, Junichi JSR Corp., Tokyo Tokyo 104-8410 (JP)
(74) Representative: TBK-Patent

(57) **Abstract**

A radiation-sensitive resin composition useful as a chemically amplified resist excelling particularly in depth of focus (DOF) and capability of substantially decreasing development defects, while maintaining excellent basic performance as a resist is provided. The radiation-sensitive resin composition comprises (A) a siloxane resin containing an acid-dissociable group and (B) a photoacid generator, wherein when a coating formed from the radiation-sensitive resin composition is exposed to radiation and heated, the contact angle (α) with water in an unexposed area and the contact angle (β) with water in an exposed area satisfy an inequality formula of (α - β) > 5.

The component (A) is preferably a compound having a structural unit (I) shown by the following formula (I) and a structural unit (II) shown by the following formula (II), 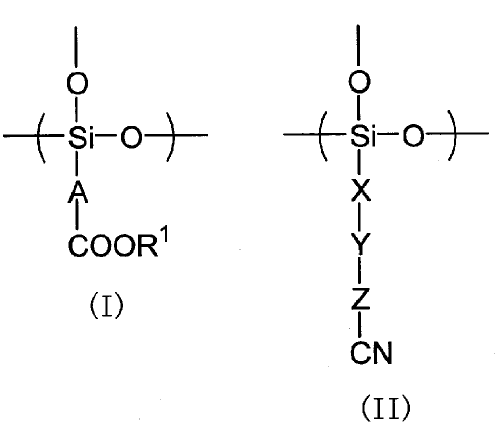 wherein A represents a substituted or unsubstituted divalent cyclic hydrocarbon group, R¹ represents a monovalent acid-dissociable group, X represents a single bond or a substituted or unsubstituted divalent hydrocarbon group, Y represents a single bond or a divalent coupling means, and Z represents a single bond or a substituted or unsubstituted divalent hydrocarbon group.

## Description

### BACKGROUND OF THE INVENTION

### FIELD OF THE INVENTION

The present invention relates to a radiation-sensitive resin composition containing a siloxane resin suitable for microprocessing using various types of radiation such as deep ultraviolet radiation, electron beams, and X-rays.

### DESCRIPTION OF BACKGROUND ART

A recent strong demand for high density and highly integrated LSIs (large-scale integrated circuits) radically accelerates miniaturization of wiring patterns.

Using short wavelength rays in a lithographic process is one method for miniaturizing wiring patterns. In recent years, deep ultraviolet radiations typified by a KrF excimer laser (wavelength: 248 nm), an ArF excimer laser (wavelength: 193 nm), or an F₂ excimer laser (wavelength: 157 nm), electron beams, X rays, and the like are being used in place of ultraviolet radiations such as g-line (wavelength: 436 nm) and i-line (wavelength: 365 nm).

Novolac resins, poly(vinylphenol) resins, and the like have been conventionally used in resist compositions. However, because these resins exhibit strong absorbance at a wavelength of 193 nm due to inclusion of aromatic rings in the structure, a lithographic process by an ArF excimer laser, for example, using these resins cannot provide high accuracy corresponding to high photosensitivity, high resolution, and a high aspect ratio.

Therefore, a resin for use in a resist, transparent to a wavelength of 193 nm or less, particularly to an ArF excimer laser (wavelength: 193 nm) or an F₂ excimer laser (wavelength: 157 nm) and exhibiting the same or higher dry etching resistance as the resist composition containing aromatic rings, has been desired. A siloxane polymer is one such resin. R. R. Kunz et al. of the MIT have reported their research results showing excellent transparency of a polysiloxane at a wavelength of 193 nm or less, particularly at 157 nm, commenting on superiority of this polymer as a resist material in a lithographic process using radiation at a wavelength of 193 nm or less (for example, J. Photopolym. Sci. Technol., Vol. 12, No. 4, 1999, P. 561-570; SPIE, Vol. 3678 (1999) P. 13-23). Moreover, polysiloxanes are known to exhibit excellent dry etching resistance. In particular, a resist containing polyorganosilsesquioxane having a ladder structure is known to possess high plasma resistance.

Several chemically amplified resist compositions using a siloxane polymer have also been reported. For example, Japanese Patent Application Laid-open No. 5-323611 discloses a radiation-sensitive resin composition comprising a polysiloxane having an acid-dissociable group such as a carboxylic acid ester group, phenol ether group, or the like on the side chain, bonded to a silicon atom via one or more carbon atoms. However, this polysiloxane cannot provide high resolution, if the acid-dissociable groups do not effciently dissociate. If a large number of acid-dissociable groups dissociate, on the other hand, the curing shrinkage stress of the resist film increases, causing cracks and peels in the resist film.

Japanese Patent Application Laid-open No. 8-160623 discloses a positive tone resist using a polymer in which the carboxyl group of poly(2-carboxyethylsiloxane) is protected with an acid-dissociable group such as a t-butyl group. Since this resist protects the carboxyl groups only insufficiently, there is a large amount of carboxylic acid components remaining in the non-exposed area. It is difficult to develop such a resist using a common alkaline developing solution.

Japanese Patent Applications Laid-open No. 11-60733 and No. 11-60734, for example, disclose a resist resin composition containing a polyorganosilsesquioxane having an acid-dissociable ester group. However, the polyorganosilsesquioxane disclosed in the Japanese Patent Application Laid-open No. 11-60733 is prepared by the addition reaction of an acid-dissociable group-containing (meth)acryl monomer to a condensation product of vinyl trialkoxysilane, γ-methacryloyloxypropyltrialkoxysilane, or the like. The resin has a problem of insufficient transparency to radiation with a wavelength of 193 nm or less due to unsaturated groups originating from the (meth) acrylic monomer remaining on the polymer side chains. The patent specification also describes a resist resin composition containing a polymer made by the esterification of poly(hydroxycarbonylethylsilsesquioxane) with t-butyl alcohol. This polymer also has the same problem as a resist as encountered by the polymer disclosed in Japanese Patent Application Laid-open No. 8-160623 due to a low degree of carboxyl group protection. In addition, although the resist resin composition of the Japanese Patent Application Laid-open No. 11-60734, in which the resin has a structural unit with a 2-cyanoethyl group bonded to the silicon atom in the polyorganosilsesquioxane main-chain, is claimed to possess excellent sensitivity and resolution, the resist resin composition is not necessarily sufficient in its overall performance as a resist.

In more recently, a chemically amplified resist containing a high molecular compound having a structural unit in which a cyclic hydrocarbon group having an acid-dissociable cyclic ester group bonds to the main chain silicon atom and another structural unit in which a cyclic hydrocarbon group having a cyano group subsistent bonds to the main chain silicon atom has been proposed by Japanese Patent Application Laid-open No. 2002-332353. The patent specification claims that the resist exhibits excellent sensitivity, resolution, and plasma etching resistance.

In addition to excellent sensitivity, resolution, pattern profile, and dry etching resistance, however, a more recent demand for chemically amplified resists, which may contain a siloxane polymer, includes excellent depth of focus (DOF) and capability of decreasing development defects that can respond to miniaturization of resist patterns.

An object of the present invention is, therefore, to provide a radiation-sensitive resin composition useful as a chemically amplified resist excelling particularly in depth of focus and capability of decreasing development defects, while maintaining excellent basic performance of a resist containing a siloxane resin.

### SUMMARY OF THE INVENTION

The present invention relates to a radiation-sensitive resin composition comprising (A) a siloxane resin containing an acid-dissociable group which dissociates with an acid and becomes alkali soluble when the acid-dissociable group dissociates and (B) a photoacid generator, wherein when a coating formed from the radiation-sensitive resin composition is exposed to radiation and heated, the contact angle (α) with water in an unexposed area and the contact angle (β) with water in an exposed area satisfy an inequality formula of (α - β) > 5.

In the above radiation-sensitive resin composition, the siloxane resin (A) preferably comprises a structural unit (I) shown by the following formula (I) and a structural unit (II) shown by the following formula (II) in the molecule, the content of the structural unit (I) in the total structural units being more than 0 mol% but 70 mol% or less and the content of the structural unit (II) in the total structural units being more than 0 mol% but 70 mol% or less. 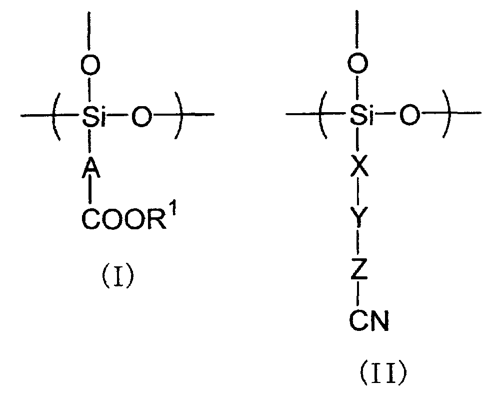 wherein A represents a substituted or unsubstituted divalent cyclic hydrocarbon group having 3-20 carbon atoms and R' represents a monovalent acid-dissociable group, X represents a single bond or a substituted or unsubstituted linear or branched divalent hydrocarbon group having 1-20 carbon atoms, Y represents a single bond, -COO-, -NHCO-, -OCOO-, -NHCOO-, or -O-, and Z represents a single bond or a substituted or unsubstituted linear or branched divalent hydrocarbon group having 1-20 carbon atoms, provided that Y and Z are not single bonds at the same time.

### DETAILED DESCRIPTION OF THE INVENTION AND

### PREFERRED EMBODIMENTS

The present invention is described below in detail.

### <Acid-dissociable group-containing siloxane resin>

The siloxane resin in the present invention is a resin containing an acid-dissociable group which dissociates with an acid and becomes alkali soluble when the acid-dissociable group dissociates (hereinafter referred to as "acid-dissociable group-containing siloxane resin"). This resin forms a coating of a radiation-sensitive resin composition prepared by mixing the resin with a photoacid generator (B) and additives that are optionally added. When the coating is exposed to radiation and heated, the contact angle (α) with water in an unexposed area and the contact angle (β) with water in an exposed area satisfy an inequality formula of (α - β) > 5, preferably (α - β) ≥ 7, and more preferably (α - β) ≥ 9.

A chemically amplified resist excelling particularly in depth of focus (DOP) and exhibiting extremely reduced developing defects can be obtained by using the acid-dissociable group-containing siloxane resin possessing such characteristics.

The acid-dissociable group-containing siloxane resin is not specifically limited insofar as the above characteristics are satisfied. For example, a resin having one or more structural units originating from a tri-functional silane compound with respect of the condensation reaction, in which the hydrogen atoms on an acidic functional group such as a carboxyl group are protected by acid-dissociable groups, and optionally further having one or more structural units originating from a tri-functional silane compound with respect of the condensation reaction, but having no acid dissociable groups or structural units originating from a di-functional or tetra-functional silane compound with respect of the condensation reaction can be given.

As a preferable acid-dissociable group-containing siloxane resin of the present invention, a siloxane resin having the structural unit (I) shown by the above formula (I) and the structural unit (II) shown by the above formula (II) in the same molecule (hereinafter referred to as "siloxane resin (a)") can be given.

The following groups are given as examples of the divalent cyclic hydrocarbon having 3-20 carbon atoms represented by A in the formula (1): Groups originating from cycloalkanes such as cyclobutane, cyclopentane, cyclohexane, cycloheptane, and cyclooctane; groups originating from bridged hydrocarbons such as adamantane, bicyclo[2.2.1]heptane, bicyclo[2.2.2]octane, tricyclo[5.2.1.0^{2,6}]decane, and tetracyclo[6.2.1.1.^{3,6}.0^{2,7}]dodecane; groups originating from aromatic hydrocarbons such as benzene, toluene, ethylbenzene, i-propylbenzene, and naphthalene; and the like.

As examples of the substituents for the divalent hydrocarbon groups represented by A, in addition to acid-dissociable groups producing a carboxyl group, an alcoholic hydroxyl group, or a phenolic hydroxyl group by the action of an acid, a fluorine atom, hydroxyl group, carboxyl group, epoxy group, oxo group, amino group, cyano group, cyanyl group, isocyanyl group, (meth)acryloyl group, (meth)acryloyloxy group, group having a lactonyl group, group having a carboxylic anhydride group, alkyl group having 1-4 carbon atoms, fluoroalkyl group having 1-4 carbon atoms, hydroxyalkyl group having 1-4 carbon atoms, cyanoalkyl group having 2-5 carbon atoms, alkoxyl group having 1-4 carbon atoms, alkoxymethyl group having 2-5 carbon atoms, alkoxycarbonyl group having 2-5 carbon atoms (excluding acid-dissociable groups), alkoxycarbonylamino group having 2-5 carbon atoms, alkoxysulfonyl group having 1-4 carbon atoms, and alkylaminosulfonyl group having 1-4 carbon atoms can be given.

Any number of one or more types of these substituents may be present in the substitution derivatives.

As A in the formula (I), groups derived from adamantane, bicyclo[2.2.1]heptane, or tetracyclo[6.2.1.1^{3,6}.0^{2,7}]dodecane, and groups obtainable by substituting these groups with a fluorine atom, trifluoromethyl group, or the like are preferable.

As preferable examples of the structural unit (I), units shown by the following formulas (I-1) to (1-5) can be given. 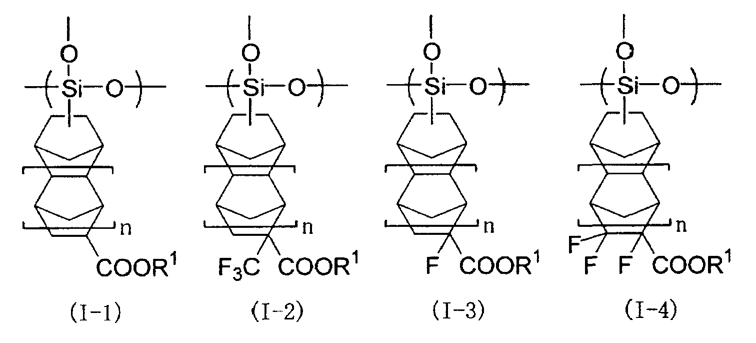 wherein n is 0 or 1. 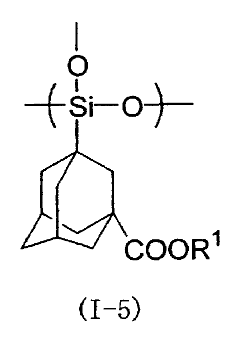 wherein R¹ is an acid dissociable group such as groups of the following formulas (1-1) to (1-3), a monovalent cyclic hydrocarbon group having 3-20 carbon atoms, a monovalent heterocyclic group having 3-20 atoms, a trialkylsilyl group (wherein the carbon atom number of the alkyl group is 1-6), or an oxoalkyl group having 4-20 carbon atoms.

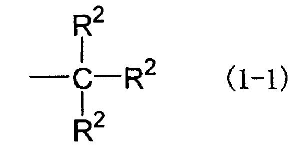

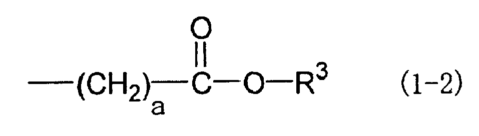

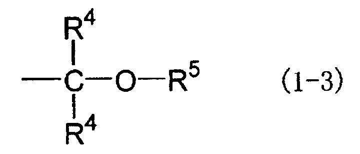

In the formula (1-1), R² individually represents a linear or branched alkyl group having 1-4 carbon atoms or a monovalent alicyclic hydrocarbon group having 4-20 carbon atoms or a substitution derivative thereof, or any two R² groups bond together to form a divalent alicyclic hydrocarbon group having 4-20 carbon atoms or a substitution derivative thereof, with the remaining R² group being a linear or branched alkyl group having 1-4 carbon atoms or a monovalent alicyclic hydrocarbon group having 4-20 carbon atoms or a substitution derivative thereof.

In the formula (1-2), R³ represents the group of the above formula (1-1), a monovalent cyclic hydrocarbon group having 3-20 carbon atoms, a monovalent heterocyclic group having 3-20 atoms, a trialkylsilyl group (wherein the carbon atom number of the alkyl group is 1-6), or an oxoalkyl group having 4-20 carbon atoms, and a represents an integer of 0-6.

In the formula (1-3), R⁴ individually represents a hydrogen atom, a linear, branched, or cyclic alkyl group having 1-20 carbon atoms, or two R⁴ groups bond together to form a ring, R⁵ represents a linear, branched, or cyclic monovalent hydrocarbon group having 1-20 carbon atoms or a monovalent heterocyclic group having 3-20 atoms, or one of R⁴ groups may bond with R⁵ to form a ring in combination, wherein the alkyl group represented by R⁴, the ring formed by two R⁴ groups, the monovalent hydrocarbon or monovalent heterocyclic group represented by R⁵, and the ring formed by R⁴ and R⁵ may be substituted.

As examples of the linear or branched alkyl group having 1-4 carbon atoms represented by R² in the formula (1-1), a methyl group, ethyl group, n-propyl group, i-propyl group, n-butyl group, 2-methylpropyl group, 1-methylpropyl group, and t-butyl group can be given.

As examples of the monovalent alicyclic hydrocarbon group having 4-20 carbon atoms represented by R² and the divalent alicyclic hydrocarbon group having 4-20 carbon atoms formed by two R² groups in combination, groups derived from a cycloalkane or cycloalkene such as cyclobutane, cyclopentane, cyclopentene, cyclohexane, cyclohexene, cycloheptane, or cyclooctane; groups derived from bridged hydrocarbons such as adamantane, bicyclo[2.2.1]heptane, bicyclo[2.2.2]octane, tricyclo[5.2.1.0^{2,6}]decane, or tetracyclo[6.2.1.1^{3,6} .0^{2,7}]dodecane; and the like can be given.

As examples of the substituents in the substituted derivative of the monovalent or divalent alicyclic hydrocarbon group, the same groups as mentioned for the substituents for divalent cyclic hydrocarbon groups represented by A in the formula (1) can be given.

Any number of one or more types of these substituents may be present in the substitution derivatives.

Examples of the groups represented by the formula (1-1) include trialkylmethyl groups such as a t-butyl group, t-amyl group, 2-ethyl-2-butyl group, 3-methyl-3-pentyl group, and 1,1-diethylpropyl group; 1-alkylcycloalkyl groups such as a 1-methylcyclopentyl group, 1-ethylcyclopentyl group, 1-n-propylcyclopentyl group, 1-methylcyclohexyl group, 1-ethylcyclohexyl group, and 1-n-propylcyclohexyl group; alkyl-substituted bridged hydrocarbon groups such as a 2-methyladamantan-2-yl group, 2-methyl-3-hydroxyadamantan-2-yl group, 2-ethyladamantan-2-yl group, 2-ethyl-3-hydroxyadamantan-2-yl group, 2-n-propyladamantan-2-yl group, 2-n-butyladamantan-2-yl group, 2- methoxymethyladamantan-2-yl group, 2-methoxymethyl-3-hydroxyadamantan-2-yl group, 2-ethoxymethyladamantan-2-yl group, 2-n-propoxymethyladamantan-2-yl group, 2-methylbicyclo[2.2.1]heptan-2-yl group, 2-methyl-5-hydroxybicyclo[2.2.1]heptan-2-yl group, 2-methyl-6-hydroxybicyclo[2.2. 1]heptan-2-yl group, 2-methyl-5-cyanobicyclo[2.2.1]heptan-2-yl group, 2-methyl-6-cyanobicyclo[2.2.1]heptan-2-yl group, 2-ethylbicyclo[2.2.1 ]heptan-2-yl group, 2-ethyl-5-hydroxybicyclo[2.2.1]heptan-2-yl group, 2-ethyl-6-hydroxybicyclo[2.2. 1]heptan-2-yl group, 8-methyltricyclo[5.2.1.0^{2,6} ]decan-8-yl group, 8-methyl-4-hydroxytricyclo[5.2. 1.0^{2,6}]decan-8-yl group, 8-methyl-4-cyanotricyclo[5.2.1.0^{2,6}]decan-8-yl group, 8-ethyltricyclo[5.2.1.0^{2,6}]decan-8-yl group, 8-ethyl-4-hydroxytricyclo[5.2.1.0^{2,6}]decan-8-yl group, 4-methyltetracyclo[6.2.1.1 ^{3,6}.0^{2,7}]dodecan-4-yl group, 4-methyl-9-hydroxytetracyclo[6.2.1.1^{3,6}.0^{2,7}]dodecan-4-yl group, 4-methyl-10-hydroxytetracyclo[6.2.1 .1^{3,6}.0^{2,7}]dodecan-4-yl group, 4-methyl-9-cyanotetracyclo[6.2.1.1^{3,6}.0^{2,7}]dodecan-4-yl group, 4-methyt-10-cyanotetracyclo[6.2.1.1^{3,6}.0^{2,7}]dodecan-4-yl group, 4-ethyltetracyclo[6.2. 1.1^{3,6}.0^{2,7}]dodecan-4-yl group, 4-ethyl-9-hydroxytetracyclo[6.2.1.1^{3,6}.0^{2,7}]dodecan-4-yl group, and 4-ethyl-10-hydroxytetracyclo[6.2.1.1^{3,6}.0^{2,7}]dodecan-4-yl group; dialkylcycloalkylmethyl groups such as a 1-methyl-1-cyclopentylethyl group, 1-methyl-1-(2-hydroxycyclopentyl)ethyl group, 1-methyl-1-(3-hydroxycyclopentyl)ethyl group, 1-methyl-1-cyclohexylethyl group, 1-methyl-1-(3-hydroxycyclohexyl)ethyl group, 1-methyl-1-(4-hydroxycyclohexyl)ethyl group, 1-methyl-1-cycloheptylethyl group, 1-methyl-1-(3-hydroxycycloheptyl)ethyl group, and 1-methyl-1-(4-hydroxycycloheptyl)ethyl group; alkyl-substituted bridged hydrocarbon group-substituted methyl groups such as a 1-methyl-1-(adamantan-1-yl)ethyl group, 1-methyl-1-(3-hydroxyadamantan-1-yl)ethyl group, I -methyl-1-(bicyclo[2.2.1] heptan-2-yl)ethyl group, 1-methyl-1-(5-hydroxybicyclo[2.2.1]heptan-2-yl)ethyl group, 1-methyl- 1-(6-hydroxybicyclo[2.2.1]heptan-2-yl)ethyl group, 1-methyl-1-(tetracyclo[6.2.1.1^{3,6}.0^{2,7}]dodecan-4-yl)ethyl group, 1-methyl-1-(9-hydroxytetracyclo[6.2.1.1^{3,1}.0^{2,7}]dodecan-4-yl)ethyl group, 1-methyl- -(10-hydroxytetracyclo[6.2.1.1^{3,6}.0^{2,7}]dodecan-4-yl)ethyl group, 1-methyl-1-(tricyclo[5.2.1.0^{2,6}]decan-8-yl)ethyl group, and 1-methyl-1-(4-hydroxytricyclo[5.2.1.0^{2,6}]decan-8-yl)ethyl group; alkyldicycloalkylmethyl groups such as a 1,1-dicyclopentylethyl group, 1,1-di(2-hydroxycyclopentyl)ethyl group, 1,1-di(3-hydroxycyclopentyl)ethyl group, 1,1-dicyclohexylethyl group, 1,1-di(3-hydroxycyclohexyl)ethyl group, 1,1-di(4-hydroxycyclohexyl)ethyl group, 1,1-dicycloheptylethyl group, 1,1-di(3-hydroxycycloheptyl)ethyl group, and 1,1-di(4-hydroxycycloheptyl)ethyl group; alkyl-substituted di(bridged hydrocarbon group)-substituted methyl groups such as a 1,1-di(adamantan-1-yl)ethyl group, 1,1-di-(3-hydroxyadamantan-1-yl)ethyl group, 1,1-di(bicyclo[2.2.1]heptan-2-yl)ethyl group, 1,1 -di(5-hydroxybicyclo[2.2.1]heptan-2-yl)ethyl group, 1, 1-di(6-hydroxybicyclo[2.2.1] heptan-2-yl)ethyl group, 1,1-di(tetracyclo[6.2.1.1^{3,6}.0^{2,7}]dodecan-4-yl)ethyl group, 1,-di(9-hydroxytetracyclo[6.2.1.1^{3,6}.0^{2,7}]dodecan-4-yl)ethyl group, 1, 1-di(10-hydroxytetracyclo[6.2.1.1^{3,6}.0^{2,7}]dodecan-4-yl)ethyl group, 1,1-di(tricyclo[5.2.1.0^{2,6}]decan-8-yl)ethyl group, and 1,1-di(4-hydroxytricyclo[5.2.1.0^{2,6})decan-8-yl)ethyl group; and the like.

As examples of the monovalent cyclic hydrocarbon group having 3-20 carbon atoms represented by R³ in the formula (1-2), a cyclobutyl group, cyclopentyl group, cyclopentenyl group, cyclohexyl group, cyclohexenyl group, cycloheptyl group, cyclooctyl group, adamantan-1-yl group, bicyclo[2.2.1]heptan-2-yl group, bicyclo[2.2.2]octyl group, tricyclo[5.2.1.0^{2,6}]decan-3-yl group, and tetracyclo[6.2.1.1^{3,6}.0^{2,7}]dodecan-4-yl group can be given.

As examples of the monovalent heterocyclic group having 3-20 atoms represented by R³, a 2-tetrahydrofuranyl group and 2-tetrahydropyranyl group can be given.

As examples of the trialkylsilyl group represented by R³, a trimethylsilyl group, ethyldimethylsilyl group, methyldiethylsilyl group, triethylsilyl group, i-propyldimethylsilyl group, methyldi-i-propylsilyl group, tri-i-propylsilyl group, and t-butyldimethylsilyl group can be given.

As examples of the oxoalkyl group having 4-20 carbon atoms represented by R³, a 3-oxocyclopentyl group, 3-oxocyclobexyl group, 4-oxocyclobexyl group, 4-methyl-2-oxooxan-4-yl group, and 5-methyl-2-oxooxolan-5-yl group can be given.

Examples of the groups represented by the formula (1-2) include a t-butoxycarbonyl group, t-amyloxycarbonyl group, 1,1-diethylpropoxycarbonyl group, 1-methylcyclopentyloxycarbonyl group, 1-ethylcyclopentyloxycarbonyl group, 1-methylcyclohexyloxycarbonyl group, 1-ethylcyclohexyloxycarbonyl group, 1-methyl-2-cyclopentenyloxycarbonyl group, 1-ethyl-2-cyclopentenyloxycarbonyl group, oxy(2-methyladamantan-2-ylxarbonyl group, oxy(2-ethyladamantan-2-yl)carbonyl group, oxy(2-methylbicyclo[2.2.1]beptan-2-yl)carbonyl group, oxy(2-ethylbicyclo[2.2.1] heptan-2-yl)carbonyl group, t-butoxycarbonylmethyl group, t-amyloxycarbonylmethyl group, 1,1-diethylpropoxycarbonylmethyl group, 1-methylcyclopentyloxycarbonylmethyl group, 1-ethylcyclopentyloxycarbonylmethyl group, 1-methylcyclohexyloxycarbonylmethyl group, 1-ethylcyclohexyloxycarbonylmethyl group, 1 -methyl-2-cyclopentenyloxycarbonylmethyl group, 1 -ethyl-2-cyclopentenyloxycarbonylmethyl group, (2-methyladamantan-2-yl)oxycarbonylmethyl group, (2-ethyladamantan-2-yl)oxycarbonylmethyl group, (2-methylbicyclo[2.2.1]heptan-2-yl)oxycarbonylmethyl group, (2-ethylbicyclo[2.2.1]heptan-2-yl)oxycarbonylmethyl group, 2-tetrahydrofuranyloxycarbonylmethyl group, 2-tetrahydropyranyloxycarbonylmethyl group, 1-methoxyethoxycarbonylmethyl group, 1-ethoxyethoxycarbonylmethyl group, carbonyl(1-methyl-1-cyclopentylethoxy)methyl group, carbonyl(1-methyl-1-cyclohexylethoxy)methyl group, [1-methyl-1-(adamantan-1-yl)ethoxy]carbonylmethyl group, [1-methyl-1-(bicyclo[2.2.1]heptan-2-yl)ethoxy]carbonylmethyl group, 2-tetrahydrofuranyloxycarbonylmethyl group, and 2-tetrahydropyranyloxycarbonylmethyl group.

In the formula (1-3), as examples of the linear, branched, or cyclic alkyl group having 1-20 carbon atoms represented by R⁴, a methyl group, ethyl group, n-propyl group, i-propyl group, n-butyl group, 2-methylpropyl group, 1-methylpropyl group, t-butyl group, n-pentyl group, neopentyl group, n-bexyl group, n-hepty) group, n-octyl group, 2-ethylhexyl group, n-nonyl group, n-decyl group, cyclobutyl group, cyclopentyl group, cyclohexyl group, cycloheptyl group, and cyclooctyl group can be given.

As examples of the ring formed by the two R⁴ groups, 3-8 member rings formed with the carbon atoms to which the two R⁴ groups bond can be given.

As examples of the linear, branched, or cyclic monovalent hydrocarbon group having 1-20 carbon atoms represented by R⁵, linear or branched alkyl groups such as a methyl group, ethyl group, n-propyl group, i-propyl group, n-butyl group, 2-methylpropyl group, 1-methylpropyl group, t-butyl group, n-pentyl group, neopentyl group, n-hexyl group, n-heptyl group, n-octyl group, 2-ethylhexyl group, n-nonyl group, and n-decyl group; cycloalkyl groups such as a cyclobutyl group, cyclopentyl group, cyclohexyl group, cycloheptyl group, and cyclooctyl group; groups originating from bridged hydrocarbons such as an adamantan-1-yl group, adamantan-2-yl group, bicyclo[2.2.1]heptan-2-yl group, bicyclo[2.2.2]octan-2-yl group, tricyclo[5.2.1.0^{2,6}]decan-3-yl group, and tetracyclo[6.2.1 .1^{3,6}.0^{2,7}]dodecan-4-yl group; aryl groups such as a phenyl group, o-tolyl group, m-tolyl group, p-tolyl group, 1-naphthyl group, and 2-naphthyl group; and aralkyl groups such as a benzyl group, α-methylbenzyl group, α,α-dimethylbenzyl group, and phenethyl group can be given.

As examples of the monovalent heterocyclic group having 3-20 atoms represented by R⁵, groups originating from nonbridged heterocyclic compounds such as oxetane, thietane, tetrahydrofurane, tetrahydrothiofurane, tetrahydropyrane, or tetrahydrothiopyrane, and groups originating from bridged heterocyclic compounds such as compounds shown by the following formulas (1-3-1) to (1-3-4) can be given.

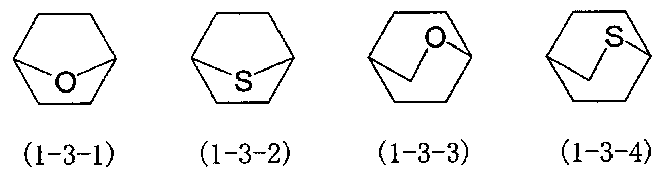

As examples of the ring formed by the R⁴ and R⁵, 3-8 member rings formed with the carbon atom to which R⁴ bonds and the oxygen atom to which R⁵ bonds can be given.

As examples of the substituents for the alkyl group represented by R⁴, the ring formed from mutual bonding of the two R⁴ groups, the monovalent hydrocarbon group or monovalent heterocyclic group represented by R⁵, and the ring formed by mutual bonding of one of the R⁴ groups and the R⁵ group, the same groups previously given as the substituents for the divalent cyclic hydrocarbon groups represented by A in the formula (I) can be given. Any number of one or more types of these substituents may be present in the substitution derivatives.

As preferable specific examples of the substituted monovalent hydrocarbon group or substituted monovalent heterocyclic group represented by R⁵ in the formula (1-3), a 4-hydroxy-n-butyl group, 6-hydroxy-n-hexyl group, 2-n-butoxyethyl group, 2-(2-hydroxyethoxy)ethyl group, (4-bydroxymethylcyclohexyl)methyl group, and the groups of the following formulas (1-3-5) to (1-3-8) can be given.

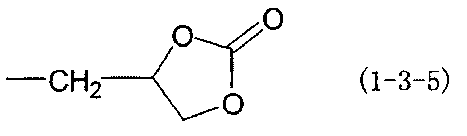

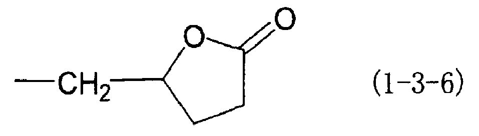

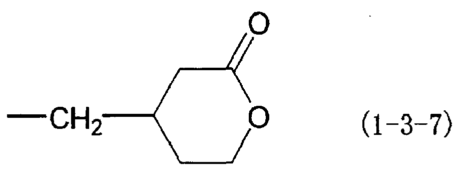

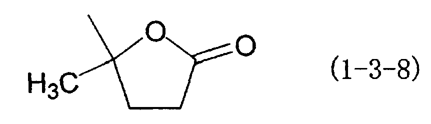

Examples of the groups represented by the formula (1-3) include substituted methyl groups such as a methoxymethyl group, ethoxymethyl group, n-propoxymethyl group, i-propoxymethyl group, n-butoxymethyl group, t-butoxymethyl group, cyclopentyloxymethyl group, cyclohexyloxymethyl group, phenoxymethyl group, benzyloxymethyl group, and phenethyloxymethyl group; 1-substituted ethyl groups such as a 1-methoxyethyl group, 1-ethoxyethyl group, 1-n-propoxyethyl group, 1-i-propoxyethyl group, 1-n-butoxyethyl group, 1-t-butoxyethyl group, 1-cyclopentyloxyethyl group, 1-cyclohexyloxyethyl group, 1-phenoxyethyl group, 1-benzyloxyethyl group, and 1-phenethyloxyethyl group; 1-methyl-1-substituted ethyl groups such as a 1-methyl-1-methoxyethyl group, 1-methyl-1-ethoxyethyl group, 1-methyl-1-n-propoxyethyl group, 1-methyl-1-i-propoxyethyl group, 1-methyl-1-n-butoxyethyl group, 1-methyl-1-t-butoxyethyl group, 1-methyl-1-cyclopentyloxyethyl group, 1-methyl-1-cyclohexyloxyethyl group, 1-methyl-1-phenoxyethyl group, 1-methyl-1-benzyloxyethyl group, and 1-methyl-1-phenethyloxyethyl group; 1-substituted-n-propyl groups such as a 1-methoxy-n-propyl group, 1-ethoxy-n-propyl group, 1-n-propoxy-n-propyl group, and 1-phenoxy-n-propyl group; 2-substituted-n-propyl groups such as a 2-methoxy-n-propyl group, 2-ethoxy-n-propyl group, 2-n-propoxy-n-propyl group, and 2-phenoxy-n-propyl group; 1-substituted-n-butyl groups such as a 1-methoxy-n-butyl group, 1-ethoxy-n-butyl group, 1-n-propoxy-n-butyl group, and 1-phenoxy-n-butyl group; and heterocyclic group such as tetrahydrofuran-2-yl group, 2-methyltetrahydrofuran-2-yl group, tetrahydropyran-2-yl group, and 2-methyltetrahydropyran-2-yl group.

As examples of the monovalent cyclic hydrocarbon groups having 3-20 carbon atoms of the monovalent acid dissociable groups represented by R¹ in the formula (I), the same groups previously mentioned in connection with the monovalent cyclic hydrocarbon groups having 3-20 carbon atoms represented by R³ in the formula (1-2) can be given.

As examples of the monovalent heterocyclic groups having 3-20 atoms of the monovalent acid dissociable groups represented by R', the same groups previously mentioned in connection with the monovalent heterocyclic groups having 3-20 atoms represented by R³ in the formula (1-2) can be given.

As examples of the trialkylsilyl groups which are monovalent acid dissociable groups represented by R¹, the same groups previously mentioned in connection with the trialkylsilyl groups represented by R³ in the formula (1-2) can be given.

As examples of the oxoalkyl groups having 4-20 carbon atoms which are monovalent acid dissociable groups represented by R¹, the same groups previously mentioned in connection with the oxoalkyl groups having 4-20 carbon atoms represented by R³ in the formula (1-2) can be given.

Of these monovalent acid-dissociable groups represented by R¹ , the groups shown by the formulas (1-1) and (1-2) are preferable, with particularly preferable groups being a t-butyl group, 1-methylcyclopentyl group, 1-ethylcyclopentyl group, 1-methylcyclohexyl group, 1-ethylcyclohexyl group, 2-metbyladamantyl group, 2-etbyladamantyl group, t-butoxycarbonylmethyl group, and the like.

The structural unit (I) may be used in the siloxane resin (a) either individually or in combination of two or more.

Next, as examples of the linear or branched divalent hydrocarbon group having 1-20 carbon atoms represented by X and Z in the formula (II), a methylene group, 1,1-ethylene group, 1,2-ethylene group, propylene group, trimethylene group, tetramethylene group, and hexamethylene group can be given.

As examples of the substituents for the divalent hydrocarbon groups of X and Z, a fluorine atom, hydroxyl group, carboxyl group, epoxy group, oxo group, amino group, cyano group, cyanyl group, isocyanyl group, (meth)acryloyl group, (meth)acryloyloxy group, group having a lactonyl group, group having a carboxylic anhydride group, alkoxyl group having 1-4 carbon atoms, alkoxycarbonyl group having 2-5 carbon atoms, alkoxycarbonylamino group having 2-5 carbon atoms, alkoxysulfonyl group having 1-4 carbon atoms, and alkylaminosulfonyl group having 1-4 carbon atoms can be given.

Any number of one or more types of these substituents may be present in the substitution derivatives.

In the formula (II), either one of the coupling means (-) of -COO-, -NHCO-, -OCOO-, and -NHCOO- represented by Y may bond to X.

In the formula (II), a methylene group, 1,2-ethylene group, propylene group, and the like are preferable as the group X, a single bond, -COO-, -O-, and the like are preferable as the group Y, and a methylene group, 1,2-ethylene group, propylene group, and the like are preferable as the group Z.

As preferable examples of the group -X-Y-Z-CN- in the structural unit (II), groups having 1-7 main chain carbon atoms forming -X-Y-Z-, such as - CH₂CN (cyanomethyl group), -CH₂CH₂CN (2-cyanoethyl group), -CH₂CH₂CH₂CN (3-cyanopropyl group), -CH₂CH₂CH₂CH₂CN (4-cyanobutyl group), and -CH₂CH₂CH₂COOCH₂CN (3-cyanomethoxycarbonylpropyl group) can be given.

The structural unit (II) may be used in the siloxane resin (a) either individually or in combination of two or more.

The amount of the structural unit (I) in the siloxane resin (a) is more than 0 mol% but not more than 70 mol%, preferably 10-60 mol%, and particularly preferably 15-50 mol% of the total amount of the structural units, whereas the amount of the structural unit (II) is more than 0 mol% but not more than 80 mol%, preferably 5-80 mol%, and particularly preferably 5-70 mol% of the total amount of the structural units. If the amount of the structural unit (I) is 0 mol%, resolution as a resist tends to decrease. If the amount exceeds 70 mol%, the resist sensitivity and pattern profile tend to be impaired. If the amount of the recurring unit (II) is 0 mol%, adhesion to substrates tends to decrease; if more than 80 mol%, on the other hand, resolution as a resist tends to decrease.

The siloxane resin (a) may further have one or more structural units other than the above structural units originating from a silane compound with tri-functionality in regard to a condensation reaction (hereinafter referred to as "other structural units"), such as a structural unit shown by the following formula (III) (hereinafter referred to as "structural unit (III)"), structural units originating from a silane compound with di- or tetra-functionality in regard to a condensation reaction, and the other structural units. 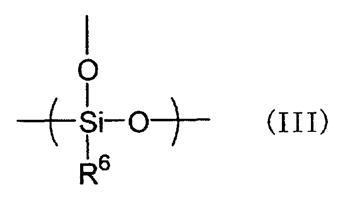 wherein R⁶ represents a substituted or unsubstituted monovalent hydrocarbon group having 1-20 carbon atoms or a substituted or unsubstituted monovalent heterocyclic group having 3-20 atoms.

As examples of the monovalent hydrocarbon group having 1-20 carbon atoms represented by R⁶ in the formula (III), linear or branched alkyl groups such as a methyl group, ethyl group, n-propyl group, i-propyl group, n-butyl group, 2-methylpropyl group, 1-methylpropyl group, t-butyl group, n-pentyl group, neopentyl group, n-hexyl group, n-heptyl group, n-octyl group, 2-ethylhexyl group, n-nonyl group, and n-decyl group; cycloalkyl groups such as a cyclobutyl group, cyclopentyl group, cyclohexyl group, cycloheptyl group, and cyclooctyl group; groups originating from bridged hydrocarbons such as an adamantan-1-yl group, adamantan-2-yl group, bicyclo[2.2.1]heptan-2-yl group, bicyclo[2.2.2]octan-2-yl group, tricyclo[5.2.1.0^{2,6}]decan-3-yl group, and tetracyclo[6.2.1.1^{3,6}.0^{2,7}]dodecan-4-yl group; aryl groups such as a phenyl group, o-tolyl group, m-tolyl group, p-tolyl group, 1-naphthyl group, and 2-naphthyl group; aralkyl groups such as a benzyl group, α-methylbenzyl group, α,α-dimethylbenzyl group, and phenethyl group; and 1-acenaphthenyl group can be given.

As examples of the monovalent heterocyclic group having 3-20 carbon atoms represented by R⁶, groups originating from nonbridged heterocyclic compounds such as oxetane, thietane, tetrahydrofurane, tetrahydrothiofurane, tetrahydropyrane, or tetrahydrothiopyrane, and groups originating from bridged heterocyclic compound such as compounds shown by the above formulas (1-3-1) to (1-3-4) can be given.

As examples of the substituents for the monovalent hydrocarbon group and monovalent heterocyclic group represented by R⁶, the same groups as mentioned for the substituents for divalent cyclic hydrocarbon groups represented by A in the formula (1) can be given.

Any number of one or more types of these substituents may be present in the substitution derivatives.

The amount of the other structural units in the siloxane resin (a) is usually 80 mol% or less, and preferably 70 mol% or less of the total amount of all structural units. If the amount of the other structural units exceeds 80 mol%, problems such as poor resist resolution, an increase in development defects, and the like may occur.

When siloxane resin (a) contains the structural unit (III) as the other structural unit, the amount of the structural unit (III) is preferably 5-80 mol%, more preferably 5-70 mol%, and particularly preferably 5-60 mol% of the total amount of the structural units.

The siloxane resin may be cross-linked intra-molecularly and/or inter-molecularly by one or more acid-dissociable coupling means shown by the following formula (2-1) or (2-2). 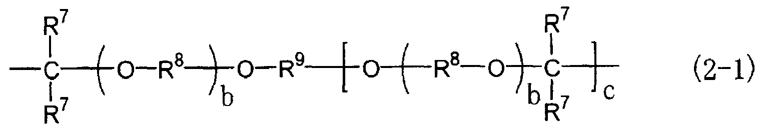 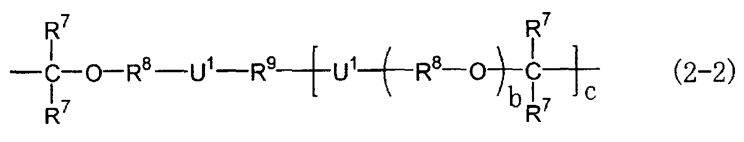 wherein R⁷ individually represents a hydrogen atom, a linear, branched, or cyclic alkyl group having 1-8 carbon atoms, or two R⁷ groups bonding to the same carbon atom may bond together to form a 3-8 member carbon ring; R⁸ individually represents a methylene group or a linear, branched, or cyclic alkylene group having 2-10 carbon atoms; b individually represents an integer of 0-10; c individually represents an integer of 1-7; R⁹ individually represents a linear or branched saturated hydrocarbon group having 1-50 carbon atoms with a valence of (c+1), a cyclic saturated hydrocarbon group having 3-50 carbon atoms with a valence of (c+1), an aromatic hydrocarbon group having 6-50 carbon atoms with a valence of (c + 1), or a heterocyclic group having 3-50 atoms with a valence of (c + 1) wherein the linear or branched saturated hydrocarbon group, cyclic saturated hydrocarbon group, aromatic hydrocarbon group, and heterocyclic group may have a hetero atom in the main chain and/or side chain, and at least part of hydrogen atoms bonded to the carbon atoms in these groups may be replaced by a fluorine atom, hydroxyl group, carboxyl group, or acyl group; and U' individually represents -COO-, -NHCOO-, or -NHCONH-, provided that one of the two coupling means (-) of -COO- or -NHCOO- may bond to R⁸ or R⁹.

Specific preferable examples of the acid-dissociable coupling means include the groups of the following formulas (2-1-1) to (2-1-8).

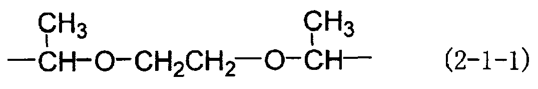

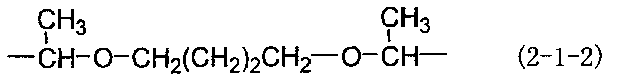

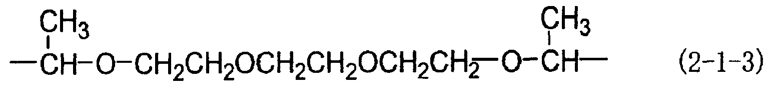

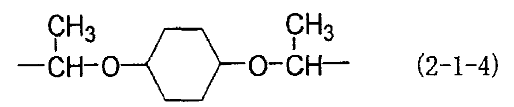

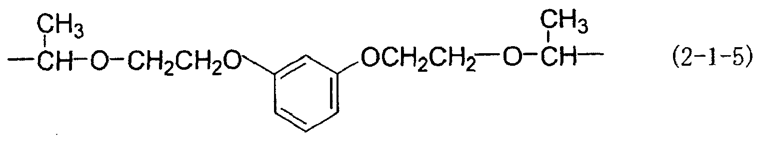

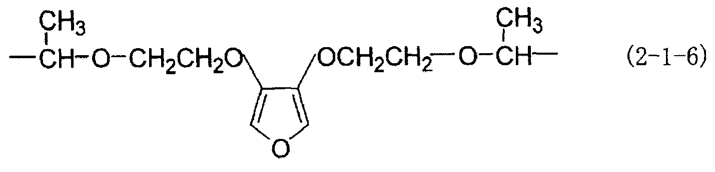

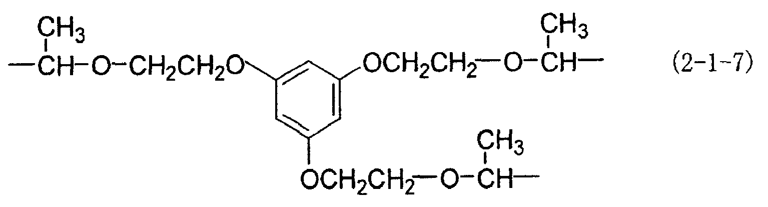

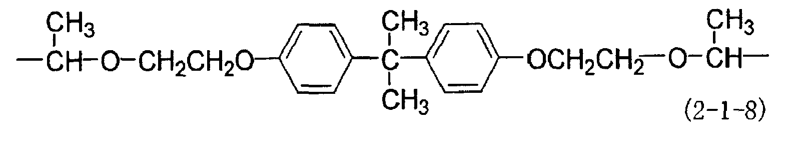

The polystyrene-reduced weight average molecular weight (hereinafter referred to as "Mw") of the acid-dissociable group-containing siloxane resin determined by gel permeation chromatography (GPC) is usually 500-1,000,000, preferably 500-100,000, and still more preferably 500-40,000. If the Mw of the acid-dissociable group-containing siloxane resin is less than 500, the glass transition temperature of the resin tends to decrease. If the Mw exceeds 1,000,000, solubility of the resin in solvents tends to decrease.

In the present invention, the acid-dissociable group-containing siloxane resins can be used either individually or in combination of two or more.

### <Preparation of siloxane resin (a)>

The siloxane resin (a) is prepared by polycondensation of condensable silane compounds corresponding to each structural unit (for example, a trichlorosilane compound, triethoxysilane compound, etc.).

Polycondensation of condensable silane compounds for producing the siloxane resin (a) can be carried out in the presence of an acidic catalyst or a basic catalyst in a solvent or without using a solvent. In the present invention, the polycondensation is carried out in the presence of an acidic catalyst or after the polycondensation in the presence of an acidic catalyst, the reaction is preferably continued in the presence of a basic catalyst.

The polycondensation method for producing the siloxane resin (a) will now be described.

As examples of the acid catalyst, hydrochloric acid, sulfuric acid, nitric acid, formic acid, acetic acid, n-propionic acid, butyric acid, valeric acid, oxalic acid, malonic acid, succinic acid, maleic acid, fumaric acid, adipic acid, phthalic acid, terephthalic acid, acetic anhydride, maleic anhydride, citric acid, boric acid, phosphoric acid, titanium tetrachloride, zinc chloride, aluminium chloride, benzenesulfonic acid, p-toluenesulfonic acid, and methanesulfonic acid can be given.

Of these acidic catalysts, hydrochloric acid, sulfuric acid, acetic acid, oxalic acid, malonic acid, maleic acid, fumaric acid, acetic anhydride, maleic anhydride, and the like are preferable.

These acidic catalysts may be used either individually or in combination of two or more.

The acidic catalysts are usually used in the amount of 0.01-10,000 parts by weight, for 100 parts by weight of all of the silane compounds.

As the basic catalyst, an inorganic base such as lithium hydroxide, sodium hydroxide, potassium hydroxide, calcium hydroxide, barium hydroxide, sodium hydrogencarbonate, potassium hydrogencarbonate, sodium carbonate, and potassium carbonate can be used.

In addition, the following organic bases can also be used as the basic catalyst: linear, branched, or cyclic monoalkylamines such as n-hexylamine, n-heptylamine, n-octylamine, n-nonylamine, n-decylamine, and cyclohexylamine; linear, branched, or cyclic dialkylamines such as di-n-butylamine, di-n-pentylamine, di-n-hexylamine, di-n-heptylamine, di-n-octylamine, di-n-nonylamine, di-n-decylamine, cyclohexylmethylamine, and dicyclohexylamine; linear, branched, or cyclic trialkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, dicyclohexylmethylamine, and tricyclohexylamine; aromatic amines such as aniline, N-methylaniline, N,N-dimethylaniline, 2-methylaniline, 3-methylaniline, 4-methylaniline, 4-nitroaniline, diphenylamine, triphenylamine, and naphthylamine; diamines such as ethylenediamine, N,N,N',N'-tetramethylethylenediamine, tetrametbylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminopbenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, and 1,3-bis[1-(4-aininophenyl)-1-methylethyl]benzene; imidazoles such as imidazole, benzimidazole, 4-methylimidazole, and 4-methyl-2-phenylimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as a piperazine and 1-(2' -hydroxyethyl)piperazine; and other nitrogen-containing heterocyclic compounds such as pyrazine, pyrazole, pyridazine, quinoxaline, purine, pyrrolidine, piperidine, morpholine, 4-methylmorpholine, 1,4-dimethylpiperazine, and 1,4-diazabicyclo[2.2.2]octane.

Of these basic catalysts, triethylamine, tri-n-propylamine, tri-n-butylamine, pyridine, and the like are preferable.

These basic catalysts may be used either individually or in combination of two or more. The basic catalyst is usually used in the amount of 0.01-10,000 parts by weight for 100 parts by weight of all of the silane compounds.

As examples of the solvent used in the polycondensation, linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 2-bydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate; alcohols such as ethanol, n-propanol, i-propanol, n-butanol, t-butanol, cyclohexanol, ethylene glycol monomethyl ether, ethylene glycol monoethyl ether, ethylene glycol mono-n-propyl ether, ethylene glycol mono-n-butyl ether, propylene glycol monomethyl ether, propylene glycol monoethyl ether, and propylene glycol mono-n-propyl ether; dialkylene glycol dialkyl ethers such as diethylene glycol dimethyl ether, diethylene glycol diethyl ether, diethylene glycol di-n-propyl ether, and diethylene glycol di-n-butyl ether; ethylene glycol monoalkyl ether acetates such as ethylene glycol monomethyl ether acetate, ethylene glycol monoethyl ether acetate, and ethylene glycol mono-n-propyl ether acetate; aromatic hydrocarbons such as toluene and xylene; other esters such as ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-metboxybutyl propionate, 3-methyl-3-methoxybutyl butyrate, ethyl acetate, n-propyl acetate, n-butyl acetate, methyl acetoacetate, ethyl acetoacetate, methyl pyruvate, and ethyl pyruvate; N-metbylpyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate; and the like can be given.

These solvents may be used either individually or in combination of two or more.

These solvents are usually used in the amount of 2,000 parts by weight or less for 100 parts by weight of all of the silane compounds.

The polycondensation reaction for producing the polysiloxane (a) can be preferably carried out either in the presence or absence of a solvent, such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, 2-octanone, cyclopentanone, 3-methylcyclopentanone, cyclohexanone, 2-methylcyclohexanone, 2,6-dimethylcyclohexanone, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, and ethylene glycol mono-n-propyl ether acetate.

In addition, water may be added to the reaction mixture of the polycondensation reaction. The amount of water to be added is usually 10,000 parts by weight or less for 100 parts by weight of all of the silane compounds. Under the acidic or basic conditions, the polycondensation reaction is carried out at a temperature of usually -50 to 300°C, and preferably 20 to 100°C, usually for a period of one minute to 100 hours.

The method for producing siloxane resins are also described in Japanese Patent Applications Laid-open No. 2002-268225, No. 2002-268226, and No. 2002-268227, for example.

### <Photoacid generator>

The photoacid generator (hereinafter referred to as "acid generator") used in the present invention is a component generating an acid by exposure to radiation. The acid causes an acid-dissociable group in the acid-dissociable group-containing siloxane resin to dissociate. As a result, an exposed part of the resist film becomes readily soluble in an alkaline developer, thereby forming a positive-tone resist pattern.

The type of the acid generator is not specifically limited insofar as it can exhibit the above action. An acid generator containing at least one compound that generates sulfonic acid or carboxylic acid (hereinafter referred to as "acid generator (b1)") upon exposure is preferable.

As examples of the sulfonic acid or carboxylic acid generated from the acid generator (b1), the compound described in Japanese Patent Application Laid-open No. 2002-220471 can be given. Specific examples include sulfonic acids or carboxylic acids having a methyl group, ethyl group, n-propyl group, i-propyl group, n-butyl group, i-butyl group, sec-butyl group, t-butyl group, n-pentyl group, n-bexyl group, n-heptyl group, n-octyl group, trifluoromethyl group, pentafluoroethyl group, heptafluoro-n-propyl group, heptafluoro-i-propyl group, nonafluoro-n-butyl group, nonafluoro-i-butyl group, nonafluoro-sec-butyl group, nonafluoro-t-butyl group, perfluoro-n-pentyl group, perfluoro-n-hexyl group, perfluoro-n-heptyl group, perfluoro-n-octyl group, groups originating from norbomane, dinorbomane, adamantane, or camphor, and substituted derivative of these groups.

As examples of the acid generator (b1), onium salt compounds generating the above sulfonic acids or carboxylic acids, sulfone compounds generating the above sulfonic acids, oxime compounds generating the above sulfonic acids, carboxylic acid compounds generating the above carboxylic acids, diazoketone compounds generating the above sulfonic acids or carboxylic acids, and halogen-containing compounds generating the above sulfonic acids or carboxylic acids can be given.

As examples of the onium salt compounds, iodonium salts and sulfonium salts (including tetrahydrothiophenium salts) can be given. Specific examples include diphenyliodonium salt, dinaphthyliodonium salt, triphenylsulfonium salt, trinaphthylsulfonium salt, diphenylmetbylsulfonium salt, dicyclohexyl-2-oxocyclohexylsulfoniwn salt, 2-oxocyclohexyldimethylulfonium salt, phenylbenzylmethylsulfonimn salt, 1-naphthyldimethylsulfonium salt, 1-naphthyldiethylsulfonium salt, 1-(naphthalen-1-yl)tetrahydrothiophenium salt, and derivatives of these salts with one or more substituents such as a hydroxyl group, alkyl group, alkoxyl group, cyano group, and nitro group.

As examples of the sulfone compounds, β-ketosulfone, β-sulfonylsulfone, -diazo compounds of these compounds, and the like can be given.

As examples of the sulfonic acid compound, sulfonic acid esters, sulfonic acid imides, arylsulfonic acid esters, and imino sulfonates can be given.

As examples of the oxime compound, aryl group-containing oximesulfonic acids can be given.

As examples of the carboxylic acid compound, carboxylic acid esters, carboxylic acid imides, and carboxylic acid cyanates can be given.

As examples of the diazoketone compound, 1,3-diketo-2-diazo compounds, diazobenzoquinone compounds, and diazonaphthoquinone compounds can be given.

As examples of the halogen-containing compound, haloalkyl group-containing hydrocarbon compounds and haloalkyl group-containing heterocyclic compounds can be given.

In the present invention, the acid generators can be used either individually or in combination of two or more. Two or more acid generators (b1) that generate different sulfonic acids can be used in combination. Two or more acid generators (b1) that generate different carboxylic acids can be used in combination. One or more acid generators (b1) that generate sulfonic acids and one or more acid generators (b1) that generate carboxylic acids can be used in combination.

The amount of the acid generator used in the present invention is usually 0.1-30 parts by weight, and preferably 0.5-20 parts by weight for 100 parts by weight of the total amount of siloxane resin from the viewpoint of ensuring sensitivity and developability as a resist. If the amount of the acid generator is less than 0.1 part by weight, sensitivity and developability may be decreased. If the amount exceeds 30 parts by weight, a rectangular resist pattern may not be obtained due to decreased transparency to radiation.

### <Additives>

Additives such as siloxane resins other than acid dissociable group-containing siloxane resin (hereinafter called "other siloxane resins"), acid diffusion controllers, solubility controllers, and surfactants may be added to the radiation-sensitive resin composition of the present invention.

As examples of the other siloxane resins, a resin possessing one or more structural units (III) and, optionally, one or more structural units originating from a silane compound having di-functional or tetra-functional groups with respect to the condensation reaction can be given.

The acid diffusion controllers control diffusion of an acid generated from the acid generator upon exposure in the resist film to suppress undesired chemical reactions in the unexposed area.

The addition of such an acid diffusion controller improves storage stability of the resulting radiation-sensitive resin composition and resolution as a resist. Moreover, the addition of the acid diffusion controller prevents the line width of the resist pattern from changing due to changes in the post-exposure delay (PED) between exposure and development, whereby a composition with remarkably superior process stability can be obtained.

As the acid diffusion controller, an organic compound containing nitrogen of which the basicity does not change during exposure or heating for forming a resist pattern is preferable.

As examples of such nitrogen-containing organic compounds, a compound of the following formula (3) (hereinafter called "acid diffusion controller (c)") can be given. 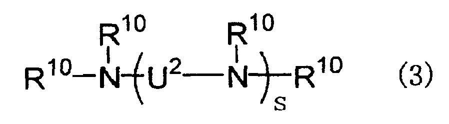 wherein R¹⁰ individually represents a hydrogen atom, a linear, branched, or cyclic alkyl group, aryl group, or aralkyl group which are either substituted or unsubstituted with a functional group such as a hydroxyl group, U² is a divalent organic group, and s is an integer of 0-2.

In the acid diffusion controller (c), the compound having s = 0 is defined as a "nitrogen-containing compound (c1)" and the compound having s = 1 or 2 is defined as a nitrogen-containing compound (c2). Polyamino compounds and polymers having three or more nitrogen atoms are collectively referred to as "nitrogen-containing compound (c3)".

As examples of nitrogen-containing organic compounds other than the acid diffusion controller (c), quaternary ammonium hydroxide compounds, amide group-containing compounds, urea compounds, and nitrogen-containing heterocyclic compounds can be given.

Examples of the nitrogen-containing compounds (c1) include mono(cyclo)alkylamines such as n-hexylamine, n-heptylamine, n-octylamine, n-nonylamine, n-decylamine, and cyclohexylamine; di(cyclo)alkylamines such as di-n-butylamine, di-n-pentylamine, di-n-hexylamine, di-n-heptylamine, di-n-octylamine, di-n-nonylamine, di-n-decylamine, cyclobexylmethylamine, and dicyclohexylamine; tri(cyclo)alkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, dicyclohexylmethylamine, and tricyclobexylamine; alkanolamines such as ethanolamine, diethanolamine, and triethanolamine; and aromatic amines such as aniline, N-methylaniline, N,N-dimethylaniline, 2-methylaniline, 3-methylaniline, 4-methylaniline, 4-nitroaniline, 2,6-dimethylaniline, 2,6-diisopropylaniline, diphenylamine, triphenylamine, and naphthylamine.

Examples of the nitrogen-containing compound (c2) include ethylenediamine, N,N,N',N'-tetramethylethylenediamine, N,N,N',N'-tetrakis(2-hydroxypropyl)ethylenediamine, tetramethylenediamine, 1,3-bis[1-(4-aminophenyl)-1-methylethyl]benzenetetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[ 1-( 4-aminophenyl)- 1-methylethyl]benzene, 1,3-bis[1-(4-aminophenyl)-1-methylethyl]benzene, bis(2-dimethylaminoethyl)ether, and bis(2-diethylaminoethyl)ether.

As examples of the nitrogen-containing compound (c3), polyethyleneimine, polyallylamine, and a polymer of 2-dimethylaminoethylacrylamide can be given.

As examples of the quaternary ammonium hydroxide compound, tetramethylammonium hydroxide, tetraethylammonium hydroxide, tetra-n-propylammonium hydroxide, and tetra-n-butylammonium hydroxide can be given.

As examples of the amide group-containing compounds, N-t-butoxycarbonyl group-containing amino compounds such as N-t-butoxycarbonyl di-n-octylamine, N-t-butoxycarbonyl di-n-nonylamine, N-t-butoxycarbonyl di-n-decylamine, N-t-butoxycarbonyl dicyclohexylamine, N-t-butoxycarbonyl-1-adamantylamine, N-t-butoxycarbonyl-N-methyl-1-adamantylamine, N,N-di-t-butoxycarbonyl-1-adamantylamine, N,N-di-t-butoxycarbonyl-N-methyl-1-adamantylamine, N-t-butoxycarbonyl-4,4'-diaminodiphenylmethane, N,N'-di-t-butoxycarbonylhexamethylenediamine, N,N,N'N'-tetra-t-butoxycarbonylhexamethylenediamine, N,N'-di-t-butoxycarbonyl-1,7-diaminoheptane, N,N'-di-t-butoxycarbonyl-1,8-diaminooctane, N,N'-di-t-butoxycarbonyl-1,9-diaminononane, N,N'-di-t-butoxycarbonyl-1,10-diaminodecane, N,N'-di-t-butoxycarbonyl- 1, 12-diaminododecane, N,N'-di-t-butoxycarbonyl-4,4'-diaminodiphenylmethane, N-t-butoxycarbonylbenzimidazole, N-t-butoxycarbonyl-2-methylbenzimidazole, N-t-butoxycarbonyl-2-phenylbenzimidazole, formamide, N-methylformamide, N,N-dimethylformamide, acetamide, N-methylacetamide, N,N-dimethylacetamide, propioneamide, benzamide, pyrrolidone, N-methylpyrrolidone, and the like can be given.

As examples of the urea compound, urea, methylurea, 1,1-dimethylurea, 1,3-dimethylurea, 1,1,3,3-tetramethylurea, 1,3-diphenylurea, and tri-n-butylthiourea can be given.

Examples of the nitrogen-containing heterocyclic compounds include: imidazoles such as imidazole, 4-methylimidazole, 1-benzyl-2-methylimidazole, 4-methyl-2-phenylimidazole, benzimidazole, and 2-phenylbenzimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as piperazine, and 1-(2-hydroxyethyl)piperazine; pyrazine, pyrazole, pyridazine, quinoxaline, purine, pyrrolidine, piperidine, 3-piperidino-1,2-propanediol, morpholine, 4-methylmorpholine, 1,4-dimethylpiperazine, and 1,4-diazabicyclo[2.2.2]octane.

These acid diffusion controllers (c) may be used either individually or in combinations of two or more.

The amount of the acid diffusion controllers to be added is usually 100 mol% or less, preferably 50 mol% or less, and still more preferably 30 mol% or less, of the acid generator. If the amount of the acid diffusion controller exceeds 100 mol%, sensitivity of the resulting resist and developability of the exposed region may be decreased. If the amount of the acid diffusion controller is less than 0.1 mol%, the pattern shape or dimensional accuracy of the resulting resist may be decreased depending on the process conditions.

As the dissolution controller, a compound possessing an effect of controlling the solubility contrast and/or rate of dissolution of the resist can be given, for example.

The amount of the dissolution controller to be added is usually 50 parts by weight or less, and preferably 30 parts by weight or less for 100 parts by weight of the total amount of the siloxane resin. If the amount of the dissolution controller exceeds 50 parts by weight, heat resistance as a resist tends to decrease.

The surfactant improves applicability, striation, developability, and the like of the radiation-sensitive resin composition.

As examples of the surfactant, nonionic surfactants such as polyoxyethylene lauryl ether, polyoxyethylene stearyl ether, polyoxyethylene oleyl ether, polyoxyethylene n-octyl phenyl ether, polyoxyethylene n-nonyl phenyl ether, polyethylene glycol dilaurate, and polyethylene glycol distearate; and commercially available products such as KP341 (manufactured by Shin-Etsu Chemical Co., Ltd.), POLYFLOW No. 75, No. 95 (manufactured by Kyoeisha Chemical Co., Ltd.), FTOP EF301, EF303, EF352 (manufactured by Tohkem Products Corporation), MEGAFAC F171, F173 (manufactured by Dainippon Ink and Chemicals, Inc.), Fluorad FC430, FC431 (manufactured by Sumitomo 3M Ltd.), Asahi Guard AG710, and Surflon S-382, SC-101, SC-102, SC-103, SC-104, SC-105, SC-106 (manufactured by Asahi Glass Co., Ltd.) can be given.

These surfactants may be used either individually or in combination of two or more.

The amount of the surfactants to be added is usually 2 parts by weight or less for 100 parts by weight of the total amount of the resin.

As other additives, halation inhibitors, adhesion promoters, storage stabilizers, anti-foaming agents, and the like can be given.

### <Preparation of composition solution>

The radiation sensitive resin composition of the present invention is usually used in the form of a composition solution prepared by dissolving the composition in a solvent so that the total solid content is usually 1-25 wt%, and preferably 2-15 wt%, and filtering the solution using a filter with a pore diameter of about 0.2 µm, for example.

As examples of solvents used for preparation of the composition solution, linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate; fluorine-containing alcohols such as 2,3-difluorobenzyl alcohol, 2,2,2-trifluorocthanol, 1,3-difluoro-2-propanol, 1,1,1-trifluoro-2-propanol, 3,3,3-trifluoro-1-propanol, 2,2,3,3,4,4,4-heptafluoro-1-butanol, 2,2,3,3,4,4,5,5-octafluoro-I-pentanol, 3,3,4,4,5,5,5-heptafluoro-2-pentanol, 1H,1H-perfluoro-1-octanol, 1H, 1H,2H,2H-perfluoro-1-octanol, 1H,1H,9H-perfluoro-1-nonanol, 1H,1H,2H,3H,3H-perfluorononane-1,2-diol, 1H,1H,2H,2H-perfluoro-1-decanol, and 1H,1H,2H,3H,3H-perfluoroundecane-1,2-diol; fluorine-containing esters such as 2,2,2-trifluoroethyl butyrate, ethyl heptafluorobutyrate, ethyl heptafluorobutylacetate, ethyl hexafluoroglutarate, ethyl 3-hydroxy-4,4,4-trifluorobutyrate, ethyl 2-methyl-4,4,4-trifluoroacetoacetate, ethyl pentafluorobenzoate, ethyl pentafluoropropionate, ethyl perfluorooctanoate, ethyl 4,4,4-trifluoroacetoacetate, ethyl 4,4,4-trifluorobutyrate, ethyl 4,4,4-trifluorocrotonate, ethyl trifluorosulfonate, ethyl 3-(trifluoromethyl)butyrate, ethyl trifluoropyruvate, ethyl trifluoroacetate, isopropyl 4,4,4-trifluoroacetoacetate, methyl perfluorodecanoate, methyl perfluoro(2-methyl-3-oxahexanoate), methyl perfluorononanoate, methyl perfluorooctanoate, methyl 2,3,3,3-tetrafluoropropionate, methyl trifluoroacetoacetate, methyl perfluoro(2,5,8-trimethyl-3,6,9-trioxadodecanoate), propylene glycol trifluoromethyl ether acetate, propylene glycol methyl ether trifluoromethylacetate, n-butyl trifluoromethylacetate, methyl 3-trifluoromethoxypropionate, 1,1,1-trifluoro-2-propylacetate, and n-butyl trifluoroacetate; fluorine-containing ethers such as 2-fluoroanisole, 3-fluoroanisole, 4-fluoroanisole, 2,3-difluoroanisole, 2,4-difluoroanisole, 2,5-difluoroanisole, 5,8-difluoro-1,4-benzodioxane, trifluoroacetaldehyde ethyl hemiacetal, 2H-perfluoro(5-methyl-3,6-dioxanonane), 2H-perfluoro(5,8,11,14-tetramethyl-3,6,9,12,15-pentaoxaoctadecane), (perfluoro-n-butyl)tetrahydrofuran , perfluoto(n-butyltetrahydrofuran), and propylene glycol trifluoromethyl ether; fluorine-containing ketones such as 2,4-difluoropropiophenone, fluorocyclohexane, 1,1,1,2,2,3,3-heptafluoro-7,7-dimethyl-4,6-octanedione, 1,1,1,3,5,5,5-heptafluoropentane-2,4-dione, 3,3,4,4,5,5,5-heptafluoro-2-pentanone, 1,1,1,2,2,6,6,6-octafluoro-2,4-hexanedione, trifluorobutanol- 1,1,1-trifluoro-5-methyl-2,4-hexanedione, and perfluorocyclohexanone; fluorine-containing amines such as trifluoroacetamide, perfluorotnbutylamine, perfluorotribexylamine, perfluorotripentylamine, and perfluorotripropylamine; fluorine-substituted cyclic hydrocarbons such as 2,4-difluorotoluene, perfluorodecalin, perfluoro(1,2-dimethylcyclohexane), and perfluoro(1,3-dimethylcyclohexane); n-propylalcohol, i-propylalcohol, n-butylalcohol, t-butylalcobol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether, toluene, xylene, ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-metboxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, ethyl pyruvate, N-methyl pyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, and propylene carbonate can be given.

These solvents may be used either individually or in combination of two or more. Among these solvents, linear or branched ketones, cyclic ketones, propylene glycol monoalkyl ether acetates, alkyl 2-hydroxypropionates, alkyl 3-alkoxypropionates, and fluorine-containing solvents are preferable.

### <Formation of resist pattern>

In the radiation-sensitive resin composition of the present invention, an acid is generated from the acid generator upon exposure to radiation. The acid-dissociable group in the acid dissociable group-containing siloxane resin dissociates by the action of the acid and generates an acid functional group such as a carboxyl group. As a result, solubility of the exposed part of the resist in an alkaline developer increases, whereby the exposed part is dissolved in an alkaline developer and removed to produce a positive-tone resist pattern.

A resist pattern is formed from the radiation-sensitive resin composition of the present invention by applying the composition solution to a substrate such as a silicon wafer or a wafer coated with aluminum, or a substrate on which a lower layer has been previously formed, using an appropriate application method such as rotational coating, cast coating, and roll coating to form a resist film. The resist film is then optionally preliminary baked (hereinafter called "PB") and exposed to form a predetermined resist pattern. Deep ultraviolet rays such as an F₂ excimer laser (wavelength: 157 nm), ArF excimer laser (wavelength: 193 nm), electron beams, X-rays, and the like are preferable as the radiation used here.

In the present invention, it is preferable to perform post-exposure bake (hereinafter called "PEB"). The PEB ensures a smooth acid dissociation reaction from the siloxane resin (a). The heating temperature for PEB is usually 30-200°C, and preferably 50-170°C, although the heating conditions vary depending on the composition of the resist.

In order to bring out maximum potentiality of the radiation-sensitive resin composition of the present invention, an organic or inorganic lower layer may be formed on the substrate as disclosed in Japanese Patent Publication No.1994-12452, for example. Moreover, a protection film may be formed on the resist film as disclosed in Japanese Patent Application Laid-open No. 1993-188598, for example, in order to prevent the effects of basic impurities and the like in the environmental atmosphere. These techniques may be employed in combination.

The exposed resist film is then developed to form a prescribed resist pattern.

As examples of the developer used for development, alkaline aqueous solutions prepared by dissolving at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, and 1,5-diazabicyclo-[4.3.0]-5-nonene are preferable.

The concentration of the alkaline aqueous solution is usually 10 wt% or less. If the concentration of the alkaline aqueous solution exceeds 10 wt%, an unexposed part may be dissolved in the developer.

Organic solvents or the like may be added to the developer containing an alkaline aqueous solution.

As examples of the organic solvents, ketones such as acetone, 2-butanone, 4-methyl-2-pentanone, cyclopentanone, cyclohexanone, 3-methylcyclopentanone, and 2,6-dimethylcyclohexanone; alcohols such as methyl alcohol, ethyl alcohol, n-propyl alcohol, i-propyl alcohol, n-butyl alcohol, t-butyl alcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol, acetonylacetone, and dimethylformamide can be given.

These organic solvents may be used either individually or in combination of two or more.

The amount of the organic solvent to be used is preferably 100 vol% or less of the alkaline aqueous solution. The amount of the organic solvent exceeding 100 vol% may decrease developability, giving rise to a larger undeveloped portion in the exposed area.

In addition, surfactants or the like may be added to the developer containing the alkaline aqueous solution in an appropriate amount.

After development using the alkaline aqueous solution developer, the resist film is generally washed with water and dried.

The radiation-sensitive resin composition of the present invention excels particularly in depth of focus (DOF) properties and produces remarkably reduced development defects, while maintaining excellent basic performance as a chemically amplified resist based on the siloxane resin. Therefore, the radiation-sensitive resin composition of the present invention can be extremely suitable for manufacturing LSIs which will become more and more minute in the future.

### EXAMPLES

The present invention is described below in more detail by examples. However, these examples should not be construed as limiting the present invention.

Mw of the siloxane resin (a) and polymers used for the lower layer-forming composition mentioned below was measured by gel permeation chromatography (GPC) using GPC columns (manufactured by Tosoh Corp., G2000HXL x 2, G3000HXL x 1, G4000HXL x 1) under the following conditions. Flow rate: 1.0 ml/minute, eluate: tetrahydrofuran, column temperature: 40°C, standard reference material: monodispersed polystyrene

### Synthesis Example 1 (Preparation of siloxane resin (a-1))

A three-necked flask equipped with a stirrer, a reflux condenser, and a thermometer was charged with 9.01 g of a silane compound of the following formula (i-1) (hereinafter referred to as "silane compound (i-1)"), 5.42 g of a silane compound of the following formula (ii-1) (hereinafter referred to as "silane compound (ii-1)"), 5.57 g of a silane compound of the following formula (iii-1) (hereinafter referred to as "silane compound (iii-1)"), 20 g of 4-methyl-2-pentanone, and 5.72 g of a 1.72 wt% aqueous solution of oxalic acid. The mixture was reacted at 80°C for six hours while stirring. The flask was cooled with ice to terminate the reaction.

Then, 7.90 g of triethylamine and 22.66 g of 4-methyl-2-pentanone were added dropwise in a nitrogen stream at 60°C over two hours. After stirring for four hours, the mixture was cooled with ice and 84.8 g of 7 wt% oxalic acid aqueous solution was added, followed by stirring. The reaction mixture was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 94 g of methanol, the mixture was stirred to obtain a homogeneous solution, which was poured into a separation funnel. 151 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 10.8 g of a purified resin. Mw of the resin was 2,330. This resin is referred to as a "siloxane resin (a-1)".

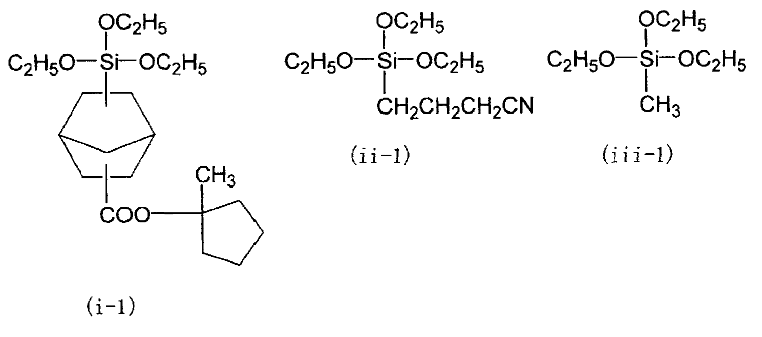

### Synthesis Example 2 (Preparation of siloxane resin (a-2))

A three-necked flask equipped with a stirrer, a reflux condenser, and a thermometer was charged with 9.65 g of a silane compound of the following formula (i-2) (hereinafter referred to as "silane compound (i-2)"), 4.94 g of a silane compound of the following formula (ii-2) (hereinafter referred to as "silane compound (ii-2)"), 5.40 g of the silane compound (iii-1), 20 g of 4-methyl-2-pentanone, and 5.56 g of a 1.72 wt% aqueous solution of oxalic acid. The mixture was reacted at 80°C for six hours while stirring. The flask was cooled with ice to terminate the reaction.

Then, 7.67 g of triethylamine and 23.18 g of 4-methyl-2-pentanone were added dropwise in a nitrogen stream at 60°C over two hours. After stirring for four hours, the mixture was cooled with ice and 81.9 g of 7 wt% oxalic acid aqueous solution was added, followed by stirring. The reaction mixture was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 97 g of methanol, the mixture was stirred to obtain a homogeneous solution, which was poured into a separation funnel. 155 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 10.7 g of a purified resin. Mw of the resin was 2,450. This resin is referred to as a "siloxane resin (a-2)".

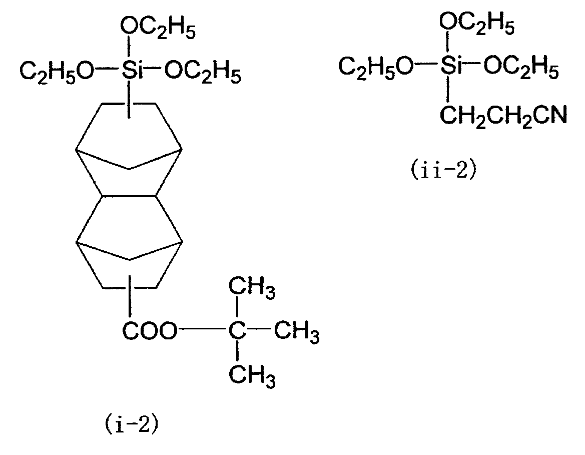

### Synthesis Example 3 (Preparation of siloxane resin (a-3))

A three-necked flask equipped with a stirrer, a reflux condenser, and a thermometer was charged with 9.5 g of the silane compound (i-2), 5.18 g of the silane compound (ii-1), 5.32 g of the silane compound (iii-1), 20 g of 4-methyl-2-pentanone, and 5.47 g of a 1.72 wt% aqueous solution of oxalic acid. The mixture was reacted at 80°C for six hours while stirring. The flask was cooled with ice to terminate the reaction.

Then, 7.55 g of triethylamine and 23.44 g of 4-methyl-2-pentanone were added dropwise in a nitrogen stream at 60°C over two hours. After stirring for four hours, the mixture was cooled with ice and 80.6 g of 7 wt% oxalic acid aqueous solution was added, followed by stirring. The reaction mixture was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 98 g of methanol, the mixture was stirred to obtain a homogeneous solution, which was poured into a separation funnel. 156 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 11.2 g of a purified resin. Mw of the resin was 2,560. This resin is referred to as a "siloxane resin (a-3)".

### Synthesis Example 4 (Preparation of siloxane resin (a-4))

A three-necked flask equipped with a stirrer, a reflux condenser, and a thermometer was charged with 9.39 g of the silane compound (i-2), 1.71 g of the silane compound (ii-1), 6.57 g of the silane compound (iii-1), 2.33 g of a silane compound of the following formula (iii-2), 20 g of 4-methyl-2-pentanone, and 5.41 g of a 1.72 wt% aqueous solution of oxalic acid. The mixture was reacted at 80°C for six hours while stirring. The flask was cooled with ice to terminate the reaction.

Then, 7.46 g of triethylamine and 23.64 g of 4-methyl-2-pentanone were added dropwise in a nitrogen stream at 60°C over two hours. After stirring for four hours, the mixture was cooled with ice and 79.7 g of 7 wt% oxalic acid aqueous solution was added, followed by stirring. The reaction mixture was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 98 g of methanol, the mixture was stirred to obtain a homogeneous solution, which was poured into a separation funnel. 158 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 10.7 g of a purified resin. Mw of the resin was 2,240. This resin is referred to as a "siloxane resin (a-4)".

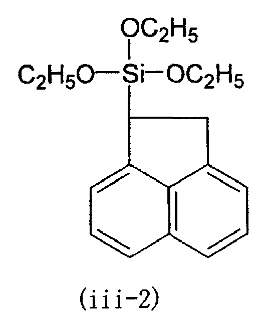

### Synthesis Example 5 (Preparation of siloxane resin (a-5))

A three-necked flask equipped with a stirrer, a reflux condenser, and a thermometer was charged with 8.81 g of the silane compound (i-2), 11.19 g of the silane compound (ii-1), 20 g of 4-methyl-2-pentanone, and 5.07 g of a 1.72 wt% aqueous solution of oxalic acid. The mixture was reacted at 80°C for six hours while stirring. The flask was cooled with ice to terminate the reaction.

Then, 7.0 g of triethylamine and 24.66 g of 4-methyl-2-pentanone were added dropwise in a nitrogen stream at 60°C over two hours. After stirring for four hours, the mixture was cooled with ice and 74.7 g of 7 wt% oxalic acid aqueous solution was added, followed by stirring. The reaction mixture was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 93 g of methanol, the mixture was stirred to obtain a homogeneous solution, which was poured into a separation funnel. 149 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 11.7 g of a purified resin. Mw of the resin was 1,880. This resin is referred to as a "siloxane resin (a-5)".

### Synthesis Example 6 (Preparation of siloxane resin (a-6))

A three-necked flask equipped with a stirrer, a reflux condenser, and a thermometer was charged with 12.78 g of the silane compound (i-2), 5.87 g of the silane compound (ii-2), 0.47 g of the silane compound (iii-2), 20 g of 4-methyl-2-pentanone, and 4.50 g of a 1.72 wt% aqueous solution of oxalic acid. The mixture was reacted at 80°C for six hours while stirring. The flask was cooled with ice to terminate the reaction. Then, 6.21 g of triethylamine and 39.57 g of 4-methyl-2-pentanone were added dropwise in a nitrogen stream at 60°C over two hours. After stirring for four hours, the mixture was cooled with ice and 66.31 g of 7 wt% oxalic acid aqueous solution was added, followed by stirring. The reaction mixture was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 109.91 g of methanol, the mixture was stirred to obtain a homogeneous solution, which was poured into a separation funnel. 175.86 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 11.06 g of a purified resin. Mw of the resin was 2,180. This resin is referred to as a "siloxane resin (a-6)".

### Comparative Synthesis Example 1 (Preparation of siloxane resin (R-1))

A three-necked flask equipped with a stirrer, a reflux condenser, and a thermometer was charged with 10.1 g of the silane compound (i-2), 9.9 g of the silane compound (iii-1), 20 g of 4-methyl-2-pentanone, and 5.82 g of a 1.72 wt% aqueous solution of oxalic acid. The mixture was reacted at 80°C for six hours while stirring. The flask was cooled with ice to terminate the reaction.

Then, 8.03 g of triethylamine and 22.4 g of 4-methyl-2-pentanone were added dropwise in a nitrogen stream at 60°C over two hours. After stirring for four hours, the mixture was cooled with ice and 85.7 g of 7 wt% oxalic acid aqueous solution was added, followed by stirring. The reaction mixture was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 93 g of methanol, the mixture was stirred to obtain a homogeneous solution, which was poured into a separation funnel. 149 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 9.5 g of a purified resin. Mw of the resin was 2,770. This resin is referred to as a "siloxane resin (R-1)".

### Preparation Example (Preparation of under layer film-forming composition)

A separable flask equipped with a thermometer was charged with 100 parts by weight of acenaphthylene, 78 parts by weight of toluene, 52 parts by weight of dioxane, and 3 parts by weight of azobisisobutyronitrile in a nitrogen atmosphere. The mixture was stirred for five hours at 70°C. Next, 5.2 parts by weight of p-toluenesulfonic acid monohydrate and 40 parts by weight of paraformaldehyde were added. After heating to 120°C, the mixture was stirred for six hours. The reaction solution was charged into a large amount of isopropanol. The resulting precipitate was collected by filtration and dried at 40°C under reduced pressure to obtain a polymer with an Mw of 22,000.

10 parts by weight of the obtained polymer, 0.5 part by weight of bis(4-t-butylphenyl)iodonium 10-camphorsulfonate, 0.5 part by weight of 4,4'-[1-{4-(1-[4-hydroxyphenyl]-1-methylethyl)phenyl} ethylidene]bisphenol, and 89 parts by weight of cyclohexanone were mixed to prepare a homogeneous solution. The solution was filtered using a membrane filter with a pore diameter of 0.1 µm to prepare an under layer film-forming composition.

### Examples 1-6 and Comparative Example 1

Siloxane resins, acid generators, and an acid diffusion controller shown in Table 1 (hereinafter "part" indicates "part by weight") were homogeneously mixed with 900 parts of 2-heptanone to prepare composition solutions. The composition solutions were applied onto a silicon wafer substrate with an under layer film previously formed thereon using a spin coater and pre-baked for 90 seconds on a hot plate at 100°C to form a resist film with a thickness of 150 nm.

The under layer film had a thickness of 300 nm, prepared by applying the above-mentioned under layer film-forming composition onto a silicon wafer by spin coating and baking the coating on a hot plate at 180°C for 60 seconds and further baking at 300°C for 120 seconds.

The resist films were exposed to an ArF excimer laser (wavelength: 193 nm, NA: 0.78, σ: 0.85) through a photomask with a line pattern of a width of 90 nm and a pitch of 180 nm formed on the entire surface using an ArF excimer laser exposure apparatus (S306C, manufactured by Nikon Corp.), while changing the amount of exposure. The films were then heated on a hot plate at 100°C for 90 seconds (PEB). The resist films were developed using a 2.38 wt% tetramethylammonium hydroxide aqueous solution at 23°C for 60 minutes, washed with water, and dried to form a positive-tone resist pattern.

The substrate for development defect inspection was produced as follows. The composition solutions were applied using a spin coater onto a silicon wafer substrate with an antireflection film ("ARC29A" manufactured by Nissan Chemical Industries, Ltd.) with a thickness of 77 nm previously formed thereon, and pre-baked for 90 seconds at 100°C to obtain a resist film with a dry thickness of 150 nm. The resist films were exposed to an ArF excimer laser through a photomask with a line pattern of a width of 110 nm and a pitch of 220 nm formed on the entire surface using an ArF excimer laser exposure apparatus ("S306C" manufactured by Nikon Corp.) to obtain a line-and-space pattern with a line width of 110 nm and a pitch of 220 nm. After performing PEB at 100°C for 90 seconds, the resist film was developed at 23°C for 60 seconds in a 2.38 wt% tetramethylammonium hydroxide aqueous solution, washed with water, and dried to form a substrate for development defect inspection. Application of the composition solutions, PB, PEB, and development were carried out using an inline system ("ACT8" manufactured by Tokyo Electron Ltd.) under the following conditions. The evaluation results are shown in Table 1.

### Sensitivity:

An optimum exposure dose at which a line-and-space pattern with a line width of 90 nm and a 180 nm pitch was formed was taken as the sensitivity.

### Contact angle:

Using a resist film obtained by application of a resist composition solution and conducting PB as an unexposed area and a resist film obtained by exposure through a sheet of plane glass at the optimum exposure dose and conducting PEB, as an exposed area, the contact angle of the unexposed area (α) and the contact angle of the exposed area (β) were determined by dropping 0.5 ml of purified water onto each of the exposed area and unexposed area and measuring the contact angles once per second over a period of 2 through 11 seconds after dropping the purified water using a contact angle measuring instrument ("DSA-10" manufactured by KRUS Electronics Ltd.). The difference of (α - β) was determined from the average of the ten measurements. The contact angles were measured within 15 minutes after PEB. The measurement was carried out at a temperature of 22-25°C and a humidity of 45-60%.

### Depth of focus (DOF):

Line and space patterns with a line width of 90 nm and a pitch of 180 nm were formed by irradiating light at an optimum exposure while moving the focus to determine the depth of focus (DOF) in which the line pattern width is between 81 nm and 99 nm.

### Development defects:

Development defects were evaluated using the substrate for development defect inspection using a development defect inspection apparatus ("KLA2351" manufactured by KLA-Tencor Corp. The number of development defects was calculated by detecting development defects extracted from the difference obtained by superposing the pixel units and a reference image in an array mode of the development defect inspection apparatus at a pixel size of 0.16 µm and a ceiling value of 13.

The acid generators and acid diffusion controller in Table 1 are as follows.

### Acid generator

b-1: Triphenylsulfonium nonafluoro-n-butanesulfonate
b-2: Triphenylsulfonium 10-camphorsulfonate

### Acid diffusion controller

c-1: N-t-butoxycarbonylbenzimidazole,

**Table 1**

| | Siloxane resin (part) | Acid generator (part) | Acid diffusion controller (part) | Contact angle (degree) | | | Sensitivity (J/m²) | DOF (µm) | Development defects (number) |
|---|---|---|---|---|---|---|---|---|---|
| | | | | α | β | α - β | | | |
| Example 1 | a-1 (100) | b-1 (5.0) | c-1 (0.3) | 78 | 68 | 10 | 400 | 0.5 | 7 |
| | | b-2 (1.5) | | | | | | | |
| Example 2 | a-2 (100) | b-2 (1.5) | - | 79 | 69 | 10 | 410 | 0.5 | 8 |
| | | b-2 (1.5) | | | | | | | |
| Example 3 | a-3(100) | b-1 (5.0) | - | 77 | 67 | 10 | 430 | 0.5 | 10 |
| | | b-2 (1.5) | | | | | | | |
| Example 4 | a-4(100) | b-1 (5.0) | c-1 (0.3) | 82 | 75 | 7 | 260 | 0.5 | 28 |
| | | b-2 (1.5) | | | | | | | |
| Example 5 | a-5 (100) | b-1 (5.0) | - | 77 | 66 | 11 | 380 | 0.5 | 9 |
| | | b-2 (1.5) | | | | | | | |
| Example 6 | a-6 (100) | b-1 (7.0 | - | 81 | 70 | 11 | 380 | 0.5 | 8 |
| | | b-2 (2.1) | | | | | | | |
| Comparative Example 1 | R-1 (100) | b-1 (5.0) | c-1 (0.3) | 84 | 80 | 4 | 470 | 0.3 | >20,000 |
| | | b-2 (1.5) | | | | | | | |

## Claims

1. A radiation-sensitive resin composition comprising (A) a siloxane resin containing an acid-dissociable group which dissociates with an acid and becomes alkali soluble when the acid-dissociable group dissociates and (B) a photoacid generator, wherein when a coating formed from the radiation-sensitive resin composition is exposed to radiation and heated, a contact angle (α) with water in an unexposed area and a contact angle (β) with water in an exposed area satisfy an inequality formula of (α - β) > 5.

2. The radiation-sensitive resin composition according to claim 1, wherein the siloxane resin (A) comprises a structural unit (I) shown by the following formula (I) and a structural unit (II) shown by the following formula (II) in the molecule, the content of the structural unit (I) in the total structural units being more than 0 mol% but 70 mol% or less and the content of the structural unit (II) in the total structural units being more than 0 mol% but 70 mol% or less, 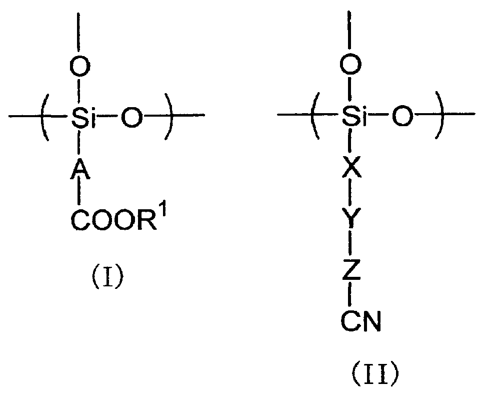 wherein A represents a substituted or unsubstituted divalent cyclic hydrocarbon group having 3-20 carbon atoms, R¹ represents a monovalent acid-dissociable group, X represents a single bond or a substituted or unsubstituted linear or branched divalent hydrocarbon group having 1-20 carbon atoms, Y represents a single bond, -COO-, -NHCO-, -OCOO-, -NHCOO-, or -O-, and Z represents a single bond or a substituted or unsubstituted linear or branched divalent hydrocarbon group having 1-20 carbon atoms, provided that Y and Z are not single bonds at the same time.

3. The radiation-sensitive resin composition according to claim 2, wherein the structural unit (I) is a unit of the following formula (I-1), (I-2), (I-3), (I-4), or (I-5), 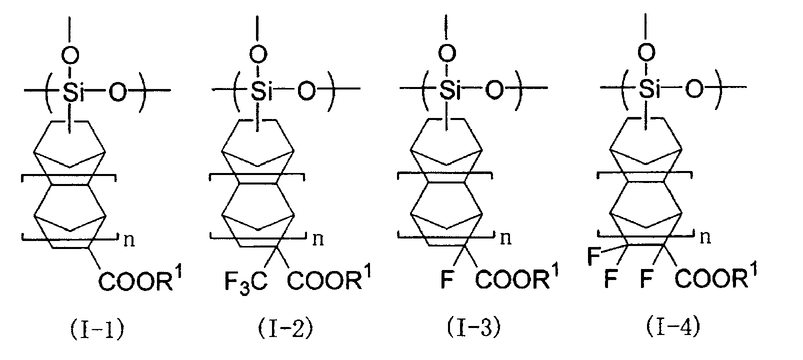 wherein R¹ is the same as defined for the formula (I) and n is 0 or 1, 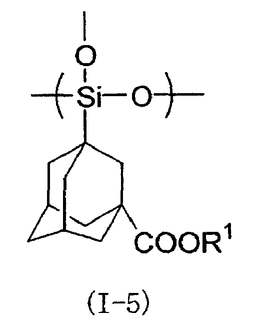 wherein R¹ is the same as defined for the formula (I).

4. The radiation-sensitive resin composition according to claim 3, wherein R¹ in the formula (I) is a group of the following formula (1-1), (1-2), or (1-3), 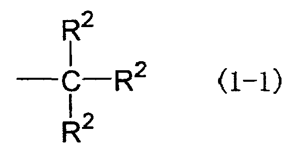 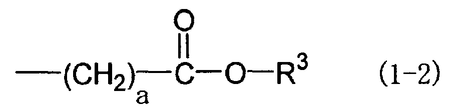 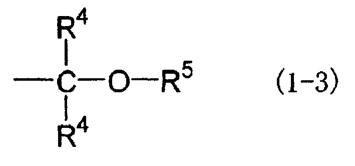 wherein R² individually represents a linear or branched alkyl group having 1-4 carbon atoms or a monovalent alicyclic hydrocarbon group having 4-20 carbon atoms or a substitution derivative thereof, or any two of R² groups bond together to form a divalent alicyclic hydrocarbon group having 4-20 carbon atoms or a substitution derivative thereof, with the remaining R² group being a linear or branched alkyl group having 1-4 carbon atoms or a monovalent alicyclic hydrocarbon group having 4-20 carbon atoms or a substitution derivative thereof, R³ represents the group of the above formula (1-1), a monovalent cyclic hydrocarbon group having 3-20 carbon atoms, a monovalent heterocyclic group having 3-20 atoms, a trialkylsilyl group (wherein the carbon atom number is 1-6), or an oxoalkyl group having 4-20 carbon atoms, a represents an integer of 0-6, R⁴ individually represents a hydrogen atom, a linear, branched, or cyclic alkyl group having 1-20 carbon atoms, or two R⁴ groups bond together to form a ring, R⁵ represents a linear, branched, or cyclic monovalent hydrocarbon group having 1-20 carbon atoms or a monovalent heterocyclic group having 3-20 atoms, or one of R⁴ groups may bond with R⁵ to form a ring in combination, wherein the alkyl group represented by R⁴, the ring formed by two R⁴ groups, the monovalent hydrocarbon or monovalent heterocyclic group represented by R⁵, and the ring formed by R⁴ and R⁵ may be substituted.

5. The radiation-sensitive resin composition according to claim 4, wherein, in the formula (II), X represents a single bond or a substituted or unsubstituted linear or branched divalent hydrocarbon group having 1-20 carbon atoms, Y represents a single bond, and Z represents a substituted or unsubstituted linear or branched divalent hydrocarbon group having 1-20 carbon atoms.

6. The radiation-sensitive resin composition according to claim 2, wherein the siloxane resin (A) further comprises a structural unit (III) shown by the following formula (III) in the molecule, 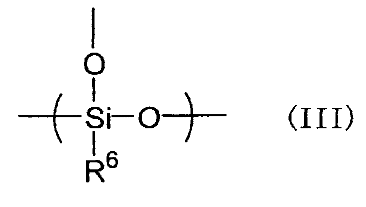 wherein R⁶ represents a substituted or unsubstituted monovalent hydrocarbon group having 1-20 carbon atoms or a substituted or unsubstituted monovalent heterocyclic group having 3-20 carbon atoms.
